(19) Europäisches Patentamt
European Patent Office
Office européen des brevets

(11) Publication number: 0 365 933 A2

(12) # EUROPEAN PATENT APPLICATION

(21) Application number: 89119025.8

(22) Date of filing: 13.10.89

(51) Int. Cl.5: C09D 127/16, C09D 5/25, C08J 3/11, C08F 214/22, H05K 3/28, H01B 3/44, H01L 21/312

(30) Priority: 25.10.88 JP 269130/88

(43) Date of publication of application: 02.05.90 Bulletin 90/18

(84) Designated Contracting States: DE FR GB

(71) Applicant: DAIKIN INDUSTRIES, LIMITED
Umeda Center Building, 4-12, Nakazaki-nishi
2-chome, Kita-ku
Osaka-shi, Osaka-fu(JP)

(72) Inventor: Inukai, Hiroshi
15-1-408, Miyata-cho 3-chome
Takatsuki-shi Osaka-fu(JP)
Inventor: Kitahara, Takahiro
1-C22-101, Tsukumodai 2-chome
Suita-shi Osaka-fu(JP)

(74) Representative: Schüler, Horst, Dr.
Kaiserstrasse 69
D-6000 Frankfurt/Main 1(DE)

(54) **Moistureproof coating composition for electronic components.**

(57) Disclosed is a moistureproof coating composition for electronic components which comprises a solvent and a resin component, the coating composition containing as the resin component a copolymer comprising about 50 to about 95 mol% of vinylidene fluoride, and about 50 to about 5 mol% of at least one copolymerizable monomer selected from the group consisting of tetrafluoroethylene, trifluoroethylene, chlorotrifluoroethylene, hexafluoropropylene, hexafluoroacetone, perfluoroalkyl vinyl ether, hexafluoroisobutylene and vinyl fluoride.

EP 0 365 933 A2

# Moistureproof Coating Composition for Electronic Components

## Field of the Invention

The present invention relates to a moistureproof coating composition for electronic components.

## Background of the Invention

Acrylic resins or the like have been heretofore used as coating materials for electronic components. However, these materials remain unsatisfactory in moisture resistance. To improve the moistureproofness, the use of acrylic resins having fluoroalkyl groups as a coating material has been proposed (see U.S. Patent No.3931454 and Japanese Unexamined Patent Publication No.189693/1986). These proposed resins, however, contain polar groups such as carbonyl group in the molecule, and thus can achieve only a slight degree of improvement in moisture resistance despite the large amount of fluorine component incorporated therein.

Fluoroolefin polymers such as polychlorofluoroethylene are known to have a markedly low moisture permeability. However, these polymers are insoluble in organic solvents, and therefore make coating operation infeasible or difficult.

## Summary of the Invention

An object of the present invention is to provide a coating composition for electronic components which has an outstanding moistureproofness.

Another object of the invention is to provide a highly moisture-proof coating composition for electronic components which can be dissolved in organic solvents to a high concentration and which is capable of forming films excellent in moisture resistance.

Other objects and features of the present invention will become apparent from the following description.

The present invention provides a moistureproof coating composition for electronic components which comprises a solvent and a resin component, the composition comprising as the resin component a copolymer comprising about 50 to about 95 mol% of vinylidene fluoride, and about 50 to about 5 mol% of at least one copolymerizable monomer selected from the group consisting of tetrafluoroethylene, trifluoroethylene, chlorotrifluoroethylene, hexafluoropropylene, hexafluoroacetone, perfluoroalkyl vinyl ether, hexafluoroisobutylene and vinyl fluoride.

Examples of the monomer to be copolymerized with vinylidene fluoride (VdF) are tetrafluoroethylene (TFE), trifluoroethylene (TrFE), hexafluoropropylene (HFP), chlorotrifluoroethylene (CTFE), perfluoroalkyl vinyl ether (PFVE), hexafluoroacetone (HFA), vinyl fluoride (VF), hexafluoroisobutylene (HFIB) and the like. Such monomers are usable singly or at least two of them can be used in mixture. Of these monomers, TFE, TrFE, HFP, CTFE, PFVE, HFA and VF are preferable in view of good copolymerizability with VdF. Specific examples of PFVE are perfluoro(methyl vinyl ether), perfluoro(propyl vinyl ether) and the like.

VdF and the other monomer are used in proportions of about 50 to about 95 mol% of the former and about 50 to about 5 mol% of the latter. If the amount of VdF is less than about 50 mol%, the copolymer is given a lower solubility and a deteriorated film-forming property. If the amount of VdF exceeds about 95 mol%, the coplymer is provided with a highly crystallizability and a lower solubility. From the viewpoint of mar resistance of the moistureproof material, it is especially desirable that the molar ratio of VdF and the other monomer be approximately 70 - 95 : 30 - 5.

Other monomers may be copolymerized with the monomers described above in such an amount that the addition does not adversely affect the properties of the copolymer, usually in an amount not more than 10% of the weight of the copolymer. Examples of such monomers are vinyl butyrate, vinyl acetate and like vinyl esters; methyl vinyl ether, cyclohexyl vinyl ether and like vinyl ethers; vinyl chloride, vinylidene chloride and like haloolefins; and others such as ethylene, propylene, styrene, methyl methacrylate, etc.

The molecular weight of the copolymer to be used in the present invention is preferably about 10000 to about 200000, calculated as the number average molecular weight.

The moistureproof coating composition for electronic components according to the present invention is in the form of a solution of the copolymer in an organic solvent.

Useful solvents are acetone, methyl ethyl ketone, methyl isobutyl ketone and like ketone solvents; tetrahydrofuran and like cyclic ether solvents; ethyl acetate, cellosolve acetate and like ester solvents; dimethylformamide, dimethylacetamide and like amide solvents; and N-methylpyrrolidone and like organic solvents. Solvents having a boiling point of not higher than 150 ° C are preferred in view of the quick-drying property.

The moistureproof coating composition for electronic components according to this invention usually has a resin concentration of about 0.1 to about 50 % by weight, preferably about 1 to about 30 % by weight. The composition in the form of a solution preferably has a viscosity of about 5000 cps or less at 35 ° C.

The moistureproof coating composition for electronic components according to the invention may contain an acrylic resin in such an amount that the incorporation of such resin does not impair the properties of the composition. The amount of the acrylic resin used is usually up to about 50% by weight, calculated as solids. In this case, a moistureproof coating composition can be produced at a reduced cost.

Examples of electronic components to be protected by the moistureproof coating composition of the present invention are printed circuit base boards, hybrid integrated circuits, resistors, condensers, etc.

The coating composition of the invention can be applied to electronic components without any specific limitation on methods, namely by known coating methods such as dipping, flow coating, brushing, roll coating or the like.

The coating composition applied to the surface of electronic components may be dried at a temperature ranging from room temperature to about 140 ° C in about 1 to about 30 minutes.

According to the invention, there is provided a moistureproof coating composition for electronic components capable of forming coatings outstanding in moisture resistance.

Since the copolymer to be used in the invention is soluble at a high concentration in an organic solvent having a relatively low boiling point, the coating composition of the invention can be easily applied and can form a film of sufficient thickness.

The features of the present invention will be clarified below with reference to the following Examples and Comparison Examples.

## Examples 1 to 6 and Comparison Examples 1 to 4

Moistureproof coating compositions for electronic components were prepared in Examples 1 to 6 and Comparison Examples 1 to 4 using the copolymers and the solvents shown below in Table 1.

Table 1

| | | | Concentration |
|---|---|---|---|
| Ex. | Copolymer | Solvent | wt.% |
| 1 | VdF:TFE = 80:20 | MEK:Acetone = 1.1 | 5 |
| 2 | VdF:TFE:HFP = 77:17:6 | MIBK | 10 |
| 3 | VdF:TFE:Vinylbutyrate = 70:20:10 | MEK:Acetone = 1:1 | 5 |
| 4 | (VdF:TFE = 80:20): PMMA = 90:10 | MEK | 5 |
| 5 | VdF:TrFE = 70:30 | MEK:Acetone = 1:1 | 10 |
| 6 | VdF:CTFE = 83.17 | MIBK:MEK = 1:1 | 5 |
| Comp. Ex.1 | 17FA:CHMA = 80:20 | 1,1,2-Trichloro-1,2,2-trifluoroethane | 5 |
| 2 | 19FA:BMA:CHMA = 30:20:50: | Metaxylene hexane fluoride: toluene = 30:70 | 20 |
| 3 | MMA | Toluene | 5 |
| 4 | Uncoated | - | - |

The abbreviations designating the monomers in Table 1 include those with the complete name shown hereinbefore. The others indicate:

17FA··· $CH_2=CHCOOCH_2CH_2C_8F_{17}$

CHMA··· $CH_2=C(CH_3)COO$ - 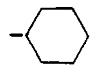

19 FA··· $CH_2=CHCOOCH_2CH_9F_{19}$

BMA··· $CH_2=C(CH_3)COOC_4H_9$

A glass-epoxy board bearing a comb-shaped electrode, (the type prescribed in item 1, JIS Z3197) was immersed in each coating composition for 30 seconds, withdrawn and dried at 50° C in 3 minutes.

The glass-epoxy board coated with the moisture-proof coating composition was tested for moistureproofness by standing in an air-conditioned chamber (EC126HH3 type, product of Hitachi, Ltd.) at 85° C and 85% RH for 1000 hours. The degrees of moistureproofness were compared before and after the test. The results are shown in Table 2 in which Comparison Example 4 indicates the result obtained without using the coating composition.

A specimen film was formed from each solution of the coating composition by a cast film process and the moisture-permeation coefficient (g.mm/m².hr.mmHG) was measured at 40° C and 90% RH according to JIS Z0208 with the results shown below in Table 2.

Table 2

| | Moisture Resistance(Ω) | | |
|---|---|---|---|
| Ex. | Initially | After 1000 hr | Moisture-permeation coefficient x $10^{-3}$ |
| 1 | 5 x $10^{13}$ | 8 x $10^{11}$ | 0.25 |
| 2 | 5 x $10^{13}$ | 7 x $10^{11}$ | 0.38 |
| 3 | 5 x $10^{13}$ | 4 x $10^{11}$ | 0.55 |
| 4 | 5 x $10^{13}$ | 2 x $10^{10}$ | 1.08 |
| 5 | 5 x $10^{13}$ | 8 x $10^{11}$ | 0.66 |
| 6 | 5 x $10^{13}$ | 3 x $10^{11}$ | 0.20 |
| Comp. Ex. 1 | 3 x $10^{13}$ | 2 x $10^{8}$ | 3.8 |
| 2 | 3 x $10^{13}$ | 8 x $10^{7}$ | 6.5 |
| 3 | 1 x $10^{13}$ | 1 x $10^{7}$ | 11 |
| 4 | 3 x $10^{13}$ | 3 x $10^{5}$ | - |

The results shown in Table 2 reveal that the moistureproof coating compositions of the present ivention exhibit excellent moisture resistance.

## Claims

1. A moistureproof coating composition for electronic components which comprises a solvent and a resin component, the coating composition comprises as the resin component a copolymer comprising about 50 to about 95 mol% of vinylidene fluoride, and about 50 to about 5 mol% of at least one copolymerizable monomer selected from the group consisting of tetrafluoroethylene, trifluoroethylene, chlorotrifluoroethylene, hexafluoropropylene, hexafluoroacetone, perfluoroalkyl vinyl ether, hexafluoroisobutylene and vinyl fluoride.

2. A moistureproof coating composition according to Claim 1 wherein the monomer to be copolymerized with the vinylidene fluoride is at least one monomer selected from the group consisting of tetrafluoroethylene, trifluoroethylene, hexafluoropropylene, chlorotrifluoroethylene, hexafluoroacetone and vinyl fluoride.

3. A moistureproof coating composition according to Claim 1 which comprises about 70 to about 95

mol% of the vinylidene fluoride and about 30 to about 5 mol% of the copolymerizable monomer.

4. A moistureproof coating composition according to Claim 1 wherein the copolymer has a number average molecular weight of about 10000 to about 200000.

5. A moistureproof coating composition according to Claim 1 wherein the solvent has a boiling point of about 150 °C or lower.

6. A moistureproof coating composition according to Claim 1 which has a resin component concentration of about 0.1 to about 50 % by weight.

7. A moistureproof coating composition according to Claim 6 which has a resin component concentration of about 1 to about 30 % by weight.

8. A moistureproof coating composition according to Claim 1 which has a viscosity of 5000 cps or less at 35 °C.

9. A method of forming a moistureproof coating on an electric component, the method comprising the steps of applying onto an electronic component a coating composition comprising a solvent and a resin component, the composition comprising as the resin component a copolymer comprising about 50 to about 95 mol% of vinylidene fluoride, and about 50 to about 5 mol% of at least one copolymerizable monomer selected from the group consisting of tetrafluoroethylene, trifluorethylene, chlorotrifluoroethyle, hexafluoropropylene, hexafluoroacetone, perfluoroalkyl vinyl ether, hexafluoroisobutylene and vinyl fluoride, and drying the coated electronic component.

10. An electronic component on which a moistureproof film of a copolymer is formed, the copolymer comprising about 50 to about 95 mol% of vinylidene fluoride, and about 50 to about 5 mol% of at least one copolymerizable monomer selected from the group consisting of tetrafluoroethylene, trifluoroethylene, chlorotrifluoroethylene, hexafluoropropylene, hexafluoroacetone, perfluoroalkyl vinyl ether, hexafluoroisobutylene and vinyl fluoride.